Europäisches Patentamt

European Patent Office

Office européen des brevets

(11) Publication number: **0 140 660 B1**

# EUROPEAN PATENT SPECIFICATION

(45) Date of publication of patent specification: **06.05.92**    (51) Int. Cl.⁵: **C23C 16/24**, //H01L21/205

(21) Application number: **84307210.9**

(22) Date of filing: **19.10.84**

(54) Method of forming amorphous polymeric halosilane films and products produced therefrom.

(30) Priority: **31.10.83 US 547156**

(43) Date of publication of application:
**08.05.85 Bulletin 85/19**

(45) Publication of the grant of the patent:
**06.05.92 Bulletin 92/19**

(84) Designated Contracting States:
**BE DE FR GB IT NL SE**

(56) References cited:
**WO-A-82/03069
DE-A- 3 208 494
DE-A- 3 429 899
GB-A- 2 087 930**

**JOURNAL OF THE ELECTROCHEMICAL SOCIETY, vol. 128, no. 12, December 1981, pages 2660-2665, Manchester, New Hampshire, US; M. JANAI et al.: "The deposition of silicon films by pyrolytic decomposition of SiF2 gas"**

**PATENT ABSTRACTS OF JAPAN, vol. 6, no. 144 (E-122)[1022], 3rd August 1982; & JP-A-57 68 018 (HANDOUTAI ENERUGII KENKYUSHO K.K.) 26-04-1982**

(73) Proprietor: **DOW CORNING CORPORATION
3901 S. Saginaw Road
Midland Michigan 48640(US)**

(72) Inventor: **Sharp, Kenneth George
1500 Whitehall Street
Midland Michigan(US)**
Inventor: **Stark, Leslie Diane
3101 Beech
Midland Michigan(US)**
Inventor: **Chu, Hsien-kun
609 Wanetah
Midland Michigan(US)**

(74) Representative: **Laredo, Jack Joseph et al
Elkington and Fife Prospect House 8 Pembroke Road
Sevenoaks, Kent TN13 1XR(GB)**

EP 0 140 660 B1

## Description

This invention relates to the discovery that pyrolysis of certain halogenated disilanes or halogenated polysilanes can result in the formation of a highly stable, highly reflective, highly abrasion-resistant photoconductive film on a substrate.

Molecular halosilanes or subvalent polymers of the general formula $(SiX_y)_n$, where X = halogen and y is less than or equal to 2, are, in general, poorly characterized materials. Such species are typically generated from base-catalyzed redistribution of halopolysilanes as described in H. J. Emeleus and M. Tufail, J. Inorg. Nucl. Chem. 29, 2081 (1967) and G. Cooper and A. Gilbert, J. Am. Chem. Soc. 82, 5042 (1960). Alternatively, such halosilanes can be made by the high temperature reaction of silicon with halomonosilanes as described in H. Schafer and J. Nickl, Z. Anorg. allgem. Chem. 274, 250 (1953) and R. Teichmann and E. Wolf, Z. anorg. allgem. Chem. 347, 145 (1966); or from the mild reaction of iodine monochloride with $CaSi_2$ as described, for example, by E. Hengge and G. Scheffler, Monats. Chem. 95, 1450 (1964). To the best of our knowledge, neither these techniques nor similar alternative techniques have been employed to generate thin polymeric films or coatings.

Polyhalo di- and polysilanes are well known; hexachlorodisilane was first described in 1871 by L. Troost and P. Hautefeuille, Ann. Chem. Phys. 7, 459 (1871). However, the known thermal decomposition chemistry of these species is limited. At temperatures in excess of 500°C., pure hexachlorodisilane can be converted into elemental silicon and silicon tetrachloride. An alternative route to silicon from hexachlorodisilane, described by Gaul and Weyenberg in U.S. Patent No. 4,374,182, issued February 15, 1983, involves the catalyzed low-temperature redistribution of hexachlorodisilane into silicon tetrachloride and silicon/chlorine polymers. These polymers, which are typically air-sensitive solids or viscous liquids, are then heated in the range 500-1450°C. to generate elemental silicon. The end product of the Gaul and Weyenberg system is pure elemental silicon.

Another well established aspect of the thermal chemistry of hexahalodisilanes is their ability to generate dihalosilylenes (such as $SiCl_2$) when heated to temperatures in excess of 400°C. See, for example, E. Chernyshev, N. Komalenkova, and S. Bashkirova, Zh. Obshch. Khim. 41, 1175 (1971). The intent of work in this area has been to "trap" the reactive silylene with other reagents. Any solid products resulting from the reaction, especially in the absence of trapping reagents, have not been well characterized. Kohlschutter and Mattner (H. Kohlschutter and H. Mattner, Z. anorg. allgem.

Chem. 282, 169 (1955)) investigated the thermal decomposition of hexachlorodisilane in a recirculating reactor. A mixture of colored, subvalent polymeric materials were formed as intractable solids, and not well characterized.

Amorphous polymeric materials of silicon and hydrogen (hereafter referred to as a-Si:H) have emerged as a new class of semiconductors in recent years. Such materials are described, for example, in D. Carlson, U.S. Patent No. 4,064,521, issued on December 20, 1976. The materials are generated as thin films from the decomposition of silane ($SiH_4$) in electrical discharges or, less frequently, from the thermal decomposition of silane or higher hydrogen-containing silanes (e.g., $Si_2H_6$, $Si_3H_8$, etc.) as described in a PCT patent application by A. MacDiarmid and Z. Kiss published as International Publication No. WO 82/03069 dated September 16, 1982. When it is desirable to include additional elemental constituents in the amorphous films, co-reactants such as phosphine ($PH_3$) or diborane ($B_2H_6$) are added to the starting materials. When fluorine is to be incorporated into an amorphous film, tetrafluorosilane ($SiF_4$) is most commonly added to the reactant mixture. This is described for example in U.S. Patent No. 4,217,374 granted to Ovshinsky and Izu on August 12, 1980.

Shimizu et al. in DE-A-3 208 494 describe a process for depositing a photoconductive layer on a carrier using a discharge. Shimizu et al. disclose a process for depositing a photo conductive layer from a gas with the components $B_2H_6(10)/Si_2F_6$; $SiF_4$ and Argon which produces coatings containing Fluorine/Silicon/Hydrogen.

A disadvantage to the use of silane or polysilanes ($Si_nH_{2n+2}$) as a starting material for generation of a-Si:H relates to the high explosion hazard of silane/air mixtures. An operational consequence of this explosion hazard is the frequent use of inert carrier gases as diluents in these systems. A disadvantage peculiar to the use of disilane is the unusually high cost of the material. Both discharge (plasma) and pyrolytic (chemical vapor deposition or CVD) routes to a-Si:H from silane have disadvantageous features. Discharge systems require relatively sophisticated and expensive equipment. Pyrolytic systems, while simple, suffer from a tendency to undergo vapor nucleation unless the pressure is very low. This behavior restricts the range of permissible operating conditions for such thermal decompositions.

The invention comprises a method to generate amorphous, colored, air-stable polymeric films with utility as semiconductors, optical or protective coatings, etc. The term "amorphous" is herein construed to include both non-crystalline and microcrystalline materials, in which the crystallites are less than 50 Å in dimension, and are not contiguous so as to form well defined grain boundaries. The films are formed from vapor phase pyrolytic decomposition of halogenated di- and polysilanes chosen from the group consisting of bromo-, chloro-, and fluoro-di- and polysilanes at temperatures in the range 250-550°C. The system pressure can be in the range of less than 133 Pa (one Torr) to greater than atmospheric. Either static or flow systems may be employed. The only significant products are an amorphous colored film and the corresponding silicon tetrahalide. Suitable substrates, such as glass, silica or a variety of metals or ceramics, may readily be coated with these films when they are present inside a decomposition reactor.

The films formed by the present method do not closely resemble elemental silicon; rather, they are amorphous Si/halogen polymers with a relatively small proportion of halogen.

The convenient starting material, hexachlorodisilane, can be used to prepare other useful reagents such as hexafluoro- or hexabromodisilane or dodecachloroneopentasilane in high yield. The hexachlorodisilane itself can be readily and inexpensively synthesized from the reaction of $CaSi_2$ with chlorine as described in E. Hengge and M. AbuShaban, Allgem. u. prakt. Chem. 18, 393 (1967) or may be obtained from process residue streams in the commercial synthesis of trichlorosilane from silicon and HCl.

Heteroatoms such as boron, phosphorus or carbon can be incorporated into the films either via modification of the disilane starting material, or by use of co-reactants such as boron trichloride. In the former case, molecules such as $CH_3Si_2Cl_5$ can be co-pyrolyzed with hexachlorodisilane to incorporate carbon atoms into the film product.

No need exists for catalysts or inert carrier gases; the pure di- or polysilanes themselves suffice. It should be noted that perhalomonosilanes such as tetrachloro- or tetrafluorosilane cannot be employed as starting materials in the decomposition to provide satisfactory films according to the invention.

A further aspect of the invention relates to the formation of electronic, electro-optical and optical devices such as solar cells, thin film transistors, or optical data storage media, which may be constructed from one or more layers of the amorphous film in combination with appropriate conductive, anti-reflective, etc. layers and other state of the art post treatment steps. A variety of possible devices based on amorphous silicon-containing films will be apparent to those skilled in the art.

The invention will become better understood by reference to the following detailed description when read in connection with the accompanying drawings wherein:

Fig. 1 is a diagrammatic view of a static system for carrying out the method of the present invention; and

Fig. 2 is a diagrammatic view of a flow system for carrying out the method of the present invention.

In its simplest form, the process of the present invention can be performed using a sealed ampoule which contains a substrate for film deposition and which has been evacuated and filled with the desired starting material or materials.

In a typical sealed tube or ampoule preparative operation, a borosilicate glass ampoule is suitable as the decomposition vessel. The ampoule will contain an appropriate substrate for film deposition such as a glass microscope slide which can be admitted before the ampoule is sealed. The choice of substrates is limited only by the need for thermal and chemical stability at the decomposition temperature in the atmosphere of the decomposition vessel. Both the ampoule and substrate are first cleaned (e.g., in an alkaline detergent) and rinsed with a highly purified solvent -- preferably water or "electronic grade" methanol. The ampoule is then attached to a vacuum line, the contents evacuated, and the container thoroughly heated under vacuum with, for example, a gas-oxygen torch. A fluoro-, chloro-, bromo-, di- or polysilane is transferred to the glass ampoule in such a manner as to preclude exposure to the atmosphere. Appropriate techniques using vacuum lines or inert-atmosphere glove boxes will be familiar to those skilled in the art.

The reaction ampoule is then sealed with a natural gas-oxygen torch and placed in an oven or furnace at the desired temperature for a time generally in the range of 10-60 minutes. During this time, the starting material decomposes and forms a film on the substrate. Then, the reaction byproduct tetrahalosilane (and any unreacted starting material, if present) may conveniently be removed by evacuation after the ampoule has been reattached to the vacuum line. The substrate may be removed for further treatment or transferred to another container at this point.

For applications in which conductive layers or contacts beneath the film are desired, these may readily be applied to the substrate via the well-known techniques of vacuum evaporation, sputtering, etc., prior to the film deposition.

For purposes of modification of electrical or optical properties of the coating, dopant or adulterant atoms may be incorporated into the film by either utilizing a functionalized starting material

such as $CH_3Si_2F_5$, for example, or by inclusion of a co-reactant such as $PF_3$ or $CH_3GeF_3$ in the reactant mixture. Care similar to that required in handling the perhalo di- or polysilane is sufficient for handling any air-sensitive doping materials. Thus, the electrical properties can be altered as desired for electronic applications or the color, for example, can be varied for optical applications with minimal processing. If desired, subsequent electrical property alteration can be accomplished by conventional means such as ion implantation. Optically readable data can be stored by exposing selected areas of the film to a laser beam.

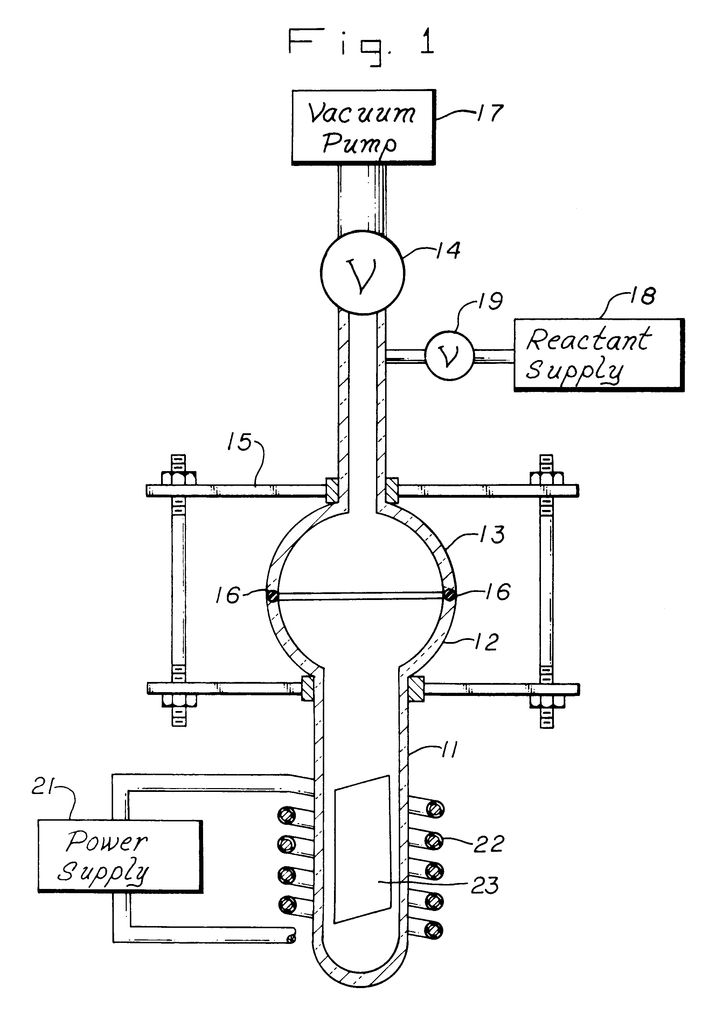

Fig. 1 illustrates a slightly more sophisticated static system for carrying out the process of the present invention. A borosilicate glass or quartz reaction chamber 11 is fitted with a high vacuum seal including a bell-shaped end coupling portion 12 designed to mate with a bell-shaped coupler 13 of a tube leading to a valve 14. The mating couplers 12 and 13 of the high vacuum seal are provided with an O-ring 16 to effect sealing therebetween upon tightening of a clamp 15 which urges the couplers together. A vacuum pump 17 is connected to the valve 14 and a reactant supply 18 provided with a valve 19 is connected into the line to provide respectively for evacuation and introduction of starting materials to the chamber 11. An electrical power supply 21 is connected to a resistance heater 22 surrounding a portion of the reaction chamber 11 which contains a substrate 23.

In this arrangement, after appropriate cleaning of the substrate, it is placed in the reaction chamber and a high vacuum seal is effected by clamping mating couplers 12 and 13 over o-ring 16. The valve 14 is opened and with the reactant supply valve 19 closed the system is evacuated. The starting reactant materials are then allowed to charge the system to the desired pressure by temporarily opening the valve 19 with the valve 14 closed. The valve 19 is then closed and power is applied to the resistance heater 22 to provide heating of the substrate to the desired temperature for the desired time. After the power supply 21 is turned off, the valve 14 is again opened and the vacuum pump reactivated to remove spent and unreacted gas. After deactivation of the pump, the reaction chamber is disconnected by loosening the high vacuum seal clamp and the coated substrate is removed. This arrangement allows rapid assembly and disassembly, accommodates large substrates more easily than use of sealed ampoules and allows multiple charges of starting material if desired.

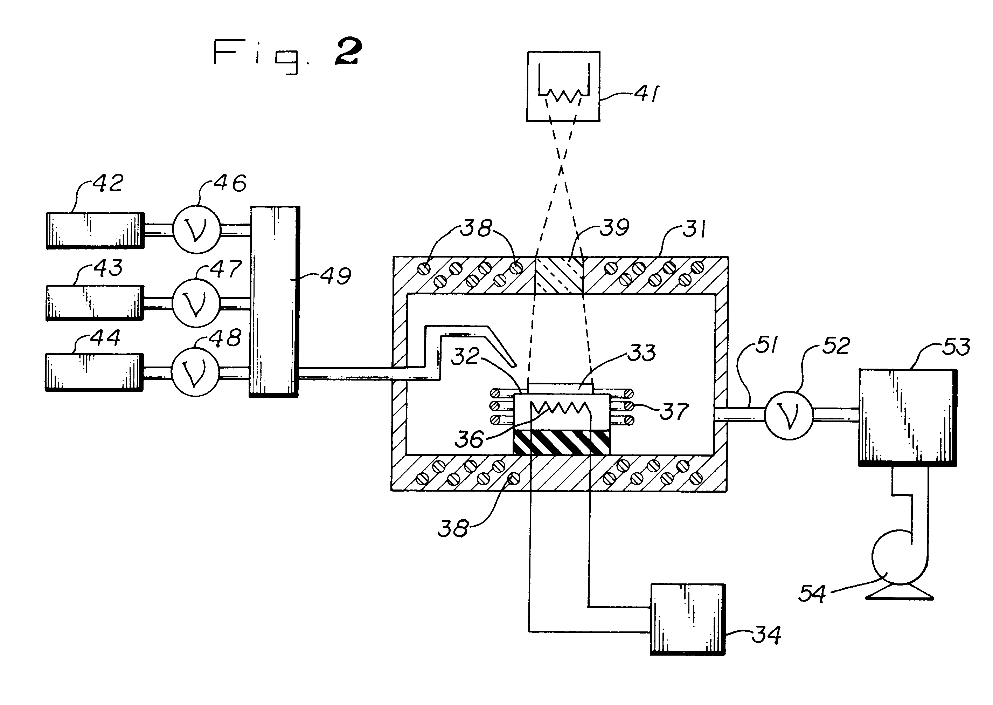

Coverage of larger surface areas can be effected and more versatility can be obtained using a flow system such as that illustrated in Fig. 2, although numerous other variations will become apparent to those skilled in the art. In Fig. 2, there is shown a reaction chamber 31 having mounted therein a pedestal 32 supporting a substrate 33. A temperature controlled power supply 34 supplies electrical heating by means such as a resistance heater 36 or a radio frequency coil 37, or both. If desired, additional heating coils 38 may be provided in the walls of the reaction chamber 31 and/or a transparent window 39 may be provided in the chamber through which radiation source 41 is focused on the substrate. The choice of heat supplies is a matter of convenience and the shape and nature of the substrate to be coated. The only requirement is that heat be supplied to the substrate in a substantially even manner to maintain substantially uniform temperatures at the substrate surface.

A plurality of gas supplies 42, 43, 44 are connected through valves 46, 47, 48 to a supply manifold 49 which mixes the gases and feeds the reaction chamber 31. The gas supplies may include supplies of reactant gases and dopant gases, for example. Pressure indicators and flow meters are preferably included in both the input lines and output line of the manifold 49. A vent line 51 regulated by a control valve 52 feeds spent gases from the reaction chamber 31 to a vent gas recovery system 53 for collection. A vacuum system 54 is connected to the vent gas recovery system to supply vacuum to the system and enable flow from the manifold outlet reaction chamber inlet through the system to the vent gas recovery system.

In operation, the substrate 33 to be coated is placed on the pedestal 32 in the reaction chamber 31 and the system is sealed. The chamber is then evacuated before starting deposition to eliminate any undesired potential reactants from the chamber. Power is applied to heat the substrate to the desired temperature and gas is allowed to flow from the gas supplies through control valves 46, 47 and/or 48. The desired gases are mixed in the manifold 49 and pass into the reaction chamber where the reactant gases are decomposed at the heated substrate and deposition takes place on the substrate surface. The reaction is maintained at the desired pressure by the vacuum control system and flow is maintained by control of the supply valves 46, 47, 48 and vent valve 52. The vent gas recovery system is designed to allow collection and suitable deposition of volatile reaction byproducts and unspent feed gases.

The description of the flow system is only exemplary and numerous variations will be apparent to those skilled in the art. The method and applicability thereof will be better understood from a reading of the following specific examples:

## Example 1

A soda-lime glass microscope slide was placed in an open-ended glass ampoule having a volume of approximately 50 ml, and all surfaces were cleaned with an alkaline detergent, then rinsed with distilled and filtered water. The end of the ampoule was then sealed with a gas-oxygen torch, and the ampoule attached to a vacuum line. The ampoule was evacuated to $1.33 \times 10^{-3}$ Pa ($10^{-5}$ Torr), then thoroughly flame dried with the torch. Hexafluorodisilane was synthesized from the reaction of hexachlorodisilane with antimony(III) fluoride. Eight one-hundredths mmol (13.6 mg) of the material was transferred into the ampoule from a reservoir on the vacuum line to give a system starting pressure of 4000 Pa (30 Torr). With the hexafluorodisilane frozen in liquid nitrogen, the neck of the ampoule was sealed with the torch. The sealed ampoule was then placed in a resistively heated tube furnace at a temperature of 350°C. for 45 minutes.

At the conclusion of the reaction, the glass substrate and the interior of the ampoule were uniformly coated with a gold, highly reflective film whose thickness was approximately 500 Å. The absorption coefficient of the film was determined to be about $10^5$/cm at 450 nm. The film did not change appearance when exposed to atmosphere for extended periods of time.

## Example 2

Example 1 was essentially repeated, except that chromium electrodes were vacuum evaporated on a glass microscope slide in a pattern of concentric circles prior to deposition of the silicon-containing film. The resistivity of the film was measured to be $10^5$ ohm-cm, and the conductivity was increased by a factor of four when irradiated with a quartz/halogen lamp having a radiance measured as 14 mw/cm$^2$. Conductivity increased with increasing temperature as per expected semiconductor behavior.

## Example 3

Example 1 was essentially repeated, except that 0.24 mmol (6.5 mg) hexachlorodisilane was used as a starting material, with the decomposition temperature of 450°C. The film was similar in appearance to that in Example 1, and displayed a volume resistivity of $3 \times 10^4$ ohm-cm.

## Example 4

Example 1 was essentially repeated except that .0012 moles (.203 g) hexafluorodisilane was used to give a system starting pressure of one atmosphere. The ampoule was heated at 270°C. for one hour. At the end of this time, the system was coated with a reflective golden brown film.

## Example 5

A film was generated in the manner of Example 1 except that approximately 50 mg hexabromodisilane was used as a starting material, and the decomposition temperature was 550°C.

## Example 6

A film was generated in the manner of Example 1 except that dodecachloroneopentasilane was used as a starting material. Fifty mg of material were used in the reaction at 450°C., with the only products detected being silicon tetrachloride and the film. The film showed comparable characteristics to those of the films cited in Examples 1 and 2.

## Example 7

A starting mixture of hexafluorodisilane and dimethyldifluorogermane in the ratio of 4:1 was utilized in the manner of the previous examples. The system was maintained at a temperature of 445°C. for 60 min. The film was considerably darker than films of comparable thickness which were generated from hexafluorodisilane only. Spectroscopic examination via ESCA confirmed the presence of germanium in the film. Visible and UV absorption spectra indicated a lower optical band gap for the germanium-containing material than in similar materials not containing germanium.

## Example 8

A film was generated in the manner of the previous examples from hexafluorodisilane at 425°C. on a soda-lime glass microscope slide. The film was golden, highly reflective, and determined to be 500 Å in thickness. The sample was irradiated with an argon ion laser with an output power of 1.4 mw at a frequency of 488 nm. A series of irradiation exposures were made at exposure times ranging from .01 to 1 sec., with the beam focussed down to several microns in diameter. In all cases, alteration of the film by the laser irradiation was easily detected microscopically. At the briefest exposure, a circular pit approximately 5 micrometers in diameter was apparent. It is, therefore, apparent that information can be stored in such films by selective laser alteration and optical readout.

Example 9

A film was generated in a flow reactor similar to that depicted in Fig. 2. Hexachlorodisilane was used as the starting material. Corning 7059 glass substrates were aligned along the flow path of the disilane precursor, and the quartz furnace tube and contents heated with an external resistive tube furnace. The reactant was admitted at the rate of 500 mg/hr. with a temperature of 550°C. measured external to the furnace tube. The substrates were successfully coated with a reflective film visually typical of films produced in the previous examples.

Example 10

A fluorosilane film sample generated as in Example 1 was subjected to abrasion resistance and weathering tests. The film was shown to be resistant to scratching with 0000 steel wool; subsequently the sample was subjected to 1000 hours of accelerated weathering testing in a model Q.U.V. weatherometer which is a cyclic ultraviolet weathering tester made by the Q Panel Company of Cleveland, Ohio. The conditions of exposure included high temperatures, humidities, and ultraviolet radiation. At the conclusion of the trial, the reflectivity and abrasion resistance of the sample were unaffected, indicating potential use for the material as a weatherable scratch resistant coating.

## Claims

1. A method of forming amorphous coloured, air-stable and abrasion resistant polymeric halosilane films on a substrate characterized by pyrolytic decomposition of at least one vapour-phase halogenated silane chosen from the group consisting of bromo-, chloro- and fluoro- di- and polysilanes at a temperature between 250°C and 550°C in a reaction chamber containing a substrate which is thermally and chemically stable at the pyrolytic decomposition temperature in the atmosphere of the reaction chamber.

2. A method as defined in Claim 1, wherein an additional compound decomposes in the presence of the di- or polysilane being used and contains an element for doping the film being produced to alter its electrical or optical characteristics.

3. A method as defined in Claim 1, wherein the di-and polysilanes contain functional groups containing a desired element for incorporating heteroatoms in the film being produced.

4. A method of forming an electrically active portion of an electronic device characterized by forming an amorphous polymeric halosilane film according to the method of Claim 1 and altering the electrical properties of the film by ion implantation.

5. A method of forming an optical readable medium which comprises forming a film according to the method of Claim 1 and selectively altering portions of the film by exposing it to a laser beam.

## Revendications

1. Procédé pour former des pellicules d'halogénosilanes polymère amorphes, colorées, stables à l'air et résistantes à l'abrasion, sur un substrat, caractérisé par la décomposition pyrolytique d'au moins un silane halogéné en phase vapeur choisi dans le groupe composé des bromo-, chloro- et fluoro- di- et polysilanes à une température entre 250° C et 550° C dans une chambre de réaction contenant un substrat qui est thermiquement et chimiquement stable à la température de décomposition pyrolytique dans l'atmosphère de la chambre de réaction.

2. Procédé suivant la revendication 1, dans lequel un composé additionnel se décompose en présence du di- ou polysilane utilisé, et contient un élément pour doper la pellicule produite afin de modifier ses caractéristiques électriques ou optiques.

3. Procédé suivant la revendication 1, dans lequel les di- et polysilanes contiennent des groupes fonctionnels comprenant un élément désiré pour incorporer des hétéroatomes dans la pellicule produite.

4. Procédé pour former une partie électriquement active d'un dispositif électronique, caractérisé par la formation d'une pellicule amorphe d'halogénosilane polymère suivant le procédé de la revendication 1 et par la modification des propriétés électriques de la pellicule au moyen d'une implantation d'ions.

**5.** Procédé pour former un milieu à lecture optique, qui comprend la formation d'une pellicule suivant le procédé de la revendication 1 et la modification sélective de parties de la pellicule par exposition à un faisceau laser.

**Patentansprüche**

**1.** Verfahren zum Ausbilden amorpher, gefärbter, luftstabiler und abriebbeständiger polymerer Halogensilanfilme auf einem Träger,
   **gekennzeichnet durch**
   pyrolytische Zersetzung von mindestens einem dampfförmigen, halogenierten Silan, ausgewählt aus der Gruppe bestehend aus Brom-, Chlor- und Fluor-, Di- und -polysilanen, bei einer Temperatur zwischen 250°C und 550°C in einer Reaktionskammer, die einen bei pyrolytischer Zersetzungstemperatur in der Atmosphäre der Reaktionskammer thermisch und chemisch stabilen Träger enthält.

**2.** Verfahren nach Anspruch 1,
   **dadurch gekennzeichnet,**
   daß man eine zusätzliche Verbindung in Gegenwart des verwendeten Di- oder Polysilans zersetzt und die ein Dotierungselement für den auszubildenden Film enthält, um seine elektrischen oder optischen Eigenschaften zu verändern.

**3.** Verfahren nach Anspruch 1,
   **dadurch gekennzeichnet,**
   daß die Di- und Polysilane funktionelle Gruppen enthalten, die ein gewünschtes Element zum Einbringen von Fremdatomen in den herzustellenden Film enthalten.

**4.** Verfahren zum Ausbilden eines elektrisch aktiven Teils einer elektronischen Vorrichtung,
   **dadurch gekennzeichnet,**
   Ausbilden eines amorphen, polymeren Halosilanfilmes nach dem Verfahren von Anspruch 1 und Verändern der elektrischen Eigenschaften des Filmes durch Ionenimplantation.

**5.** Verfahren zum Ausbilden eines optisch lesbaren Mediums durch Ausbilden eines Filmes gemäß dem Verfahren nach Anspruch 1 und selektives Verändern von Teilen des Filmes durch Aussetzen einem Laserstrahl.

Fig. 1

Fig. 2